# DEMANDE DE BREVET EUROPEEN

(11) **EP 4 796 933 A1**
(43) Date de publication de la demande: **26.08.2026**
(21) Numéro de dépôt: 26157983.3
(22) Date de dépôt: 11.02.2026
(51) Int. Cl.: G01R 1/20, G01R 15/14, G01R 15/18

(54) **MESURE DE COURANTS FORTS AU TRAVERS D'UN TRANSFORMATEUR**

(30) Priorité: 20.02.2025 FR 2501782
(71) Demandeur: SAGEMCOM ENERGY & TELECOM SAS, 92270 Bois-Colombes (FR)
(72) Inventeur: GRINCOURT, Christophe, 92270 BOIS-COLOMBES (FR); FAURE, Christophe, 92270 BOIS-COLOMBES (FR); TEBOULLE, Henri, 92270 BOIS-COLOMBES (FR)
(74) Mandataire: Cabinet Boettcher

(57) **Abrégé**

Dispositif de mesure de courant (10) comprenant :
- un barreau principal (21) ;
- un dispositif de barreau secondaire (22) comprenant une première extrémité et une deuxième extrémité fixées au barreau principal, de sorte que le courant principal se divise en un premier courant (I1) circulant dans le barreau principal entre la première extrémité et la deuxième extrémité du dispositif de barreau secondaire, et un deuxième courant (12) circulant dans le dispositif de barreau secondaire ;
- un transformateur de courant (20), comprenant un noyau magnétique (25) au travers duquel s'étend le dispositif de barreau secondaire (22), le transformateur de courant permettant ainsi de mesurer le deuxième courant qui est représentatif du courant principal.

## Description

L'invention concerne les dispositifs de mesure de courant.

### ARRIERE PLAN

Certains compteurs électriques sont conçus pour mesurer des courants forts, qui sont égaux par exemple à 200A ou 320A.

Dans un compteur électrique, la mesure du courant (pour un compteur monophasé) ou des courants (pour un compteur polyphasé) est classiquement réalisée en utilisant un transformateur de mesure de courant pour chaque phase. En effet, les transformateurs de courant présentent un grand nombre de qualité : ils sont précis, fiables, robustes, et ils permettent de réaliser une isolation galvanique entre la partie « puissance » et la partie « mesure » du compteur.

Cependant, pour des courants forts, et notamment pour des courants supérieurs à 100A, l'utilisation de transformateurs de courant devient problématique. En effet, un transformateur adapté à de tels courants présente des dimensions importantes. Or, le volume total du boîtier du compteur est généralement imposé par le client (le distributeur d'énergie ou le gestionnaire du réseau) qui achète le compteur au fabricant du compteur. L'utilisation de transformateurs de courant volumineux est donc très contraignante pour le fabricant du compteur, car elle complexifie très nettement l'intégration des différents composants à l'intérieur du compteur. La masse du compteur est aussi augmentée. De plus, ces transformateurs volumineux ont un coût élevé, ce qui augmente le coût récurrent de chaque compteur.

Par ailleurs, et indépendamment du niveau de courant mesuré par le compteur, les transformateurs de courant sont sensibles aux champs magnétiques. Certains individus malintentionnés en profitent pour tenter de frauder en approchant du compteur un aimant de type SuperMagnet pour perturber les mesures réalisées par le ou les transformateurs de courant.

### OBJET

L'invention a pour objet de faciliter l'intégration des différents composants à l'intérieur d'un compteur électrique, de réduire la masse et le coût du compteur électrique, et de réduire sa vulnérabilité aux tentatives de fraude « magnétiques ».

### RESUME

En vue de la réalisation de ce but, on propose un dispositif de mesure de courant, agencé pour mesurer un courant principal circulant dans le dispositif de mesure de courant, et comprenant :
- un barreau principal ;
- un dispositif de barreau secondaire comprenant une première extrémité et une deuxième extrémité fixées au barreau principal, de sorte que le courant principal se divise en un premier courant circulant dans le barreau principal entre la première extrémité et la deuxième extrémité du dispositif de barreau secondaire, et un deuxième courant circulant dans le dispositif de barreau secondaire ;
- un transformateur de courant, comprenant un noyau magnétique au travers duquel s'étend le dispositif de barreau secondaire, le transformateur de courant permettant ainsi de mesurer le deuxième courant qui est représentatif du courant principal.

Le deuxième courant, obtenu par division du courant principal et donc représentatif de celui-ci, a une intensité possiblement très inférieure à celle du courant principal. Il suffit pour cela que la résistance du dispositif de barreau secondaire soit très supérieure à celle de la portion du barreau principal située entre les extrémités du dispositif de barreau secondaire.

Les dimensions du transformateur de courant, qui dépendent du courant effectivement mesuré, peuvent donc être réduites de manière très significative.

On facilite de la sorte l'intégration des différents composants à l'intérieur du compteur électrique, et on réduit la masse et le coût du compteur électrique qui intègre un ou plusieurs dispositifs de mesure de courant.

De plus, comme les transformateurs sont plus petits, le fabricant du compteur bénéficie d'une plus grande latitude dans le choix du positionnement des transformateurs dans le boîtier. Il est ainsi possible d'éloigner les transformateurs des parois internes du boîtier du compteur. Il est alors plus difficile de perturber les mesures à l'aide d'un aimant.

On propose de plus un dispositif de mesure de courant tel que précédemment décrit, dans lequel la première extrémité et la deuxième extrémité du dispositif de barreau secondaire sont fixées au barreau principal par clinchage.

On propose de plus un dispositif de mesure de courant tel que précédemment décrit, dans lequel la première extrémité et la deuxième extrémité du dispositif de barreau secondaire sont fixées au barreau principal par rivetage à chaud ou à froid, ou par soudure électrique par point.

On propose de plus un dispositif de mesure de courant tel que précédemment décrit, dans lequel le dispositif de barreau secondaire comporte une première butée axiale et une deuxième butée axiale entre lesquelles est positionné le transformateur de courant et qui définissent une position axiale du transformateur de courant.

On propose de plus un dispositif de mesure de courant tel que précédemment décrit, dans lequel le dispositif de barreau secondaire comprend un premier bras dont une première extrémité est la première extrémité du dispositif de barreau secondaire, un deuxième bras dont une première extrémité est la deuxième extrémité du dispositif de barreau secondaire, et un troisième bras positionné entre une deuxième extrémité du premier bras et une deuxième extrémité du deuxième bras, le troisième bras s'étendant au travers du noyau magnétique du transformateur de courant.

On propose de plus un dispositif de mesure de courant tel que précédemment décrit, dans lequel une largeur du troisième bras est inférieure à une largeur du premier bras et à une largeur du deuxième bras, de sorte que l'interface entre le troisième bras et le premier bras forme un premier épaulement constituant la première butée axiale et l'interface entre le troisième bras et le deuxième bras forme un deuxième épaulement constituant la deuxième butée axiale.

On propose de plus un dispositif de mesure de courant tel que précédemment décrit, dans lequel le premier bras et le deuxième bras s'étendent tous deux depuis une même face du barreau principal, dans lequel le troisième bras s'étend dans le prolongement deuxième bras, et dans lequel le deuxième bras est plié de sorte que le troisième bras est décalé en hauteur par rapport au premier bras pour permettre de positionner une extrémité libre du troisième bras sur une face du premier bras.

On propose de plus un équipement électrique comprenant au moins un dispositif de mesure de courant tel que précédemment décrit.

On propose de plus un équipement électrique tel que précédemment décrit, l'équipement électrique étant un compteur électrique.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés parmi lesquels :
[Fig. 1] la figure 1 représente un schéma d'un compteur électrique triphasé intégrant trois dispositifs de mesure de courant ;
[Fig. 2] la figure 2 représente une vue en perspective et de dessus du dispositif de mesure de courant ;
[Fig. 3] la figure 3 représente une vue en perspective et de dessous du dispositif de mesure de courant ;
[Fig. 4] la figure 4 représente les étapes d'un procédé de clinchage.

### DESCRIPTION DETAILLEE

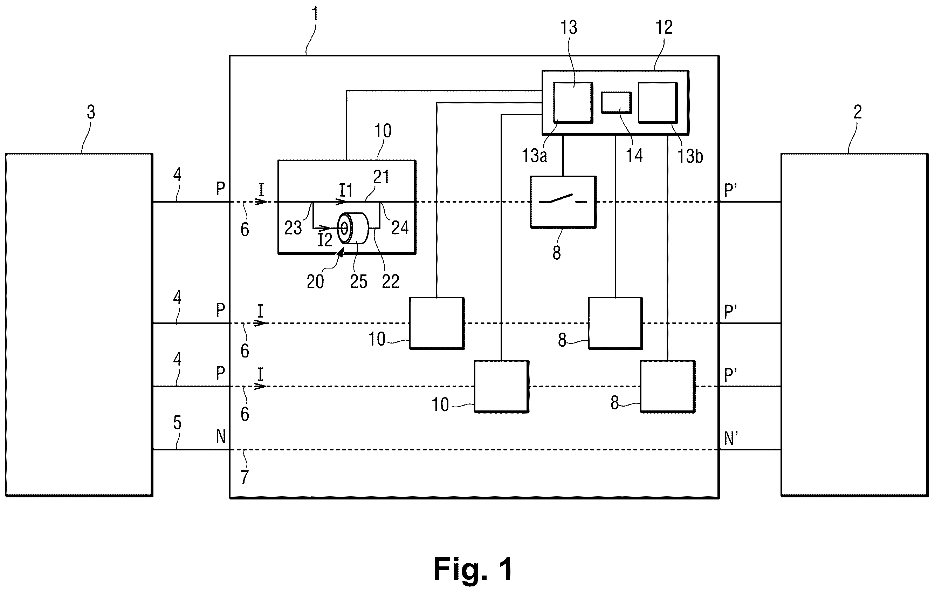

En référence à la figure 1, le compteur électrique 1 est destiné à mesurer la consommation d'énergie électrique d'une installation 2. Cette énergie électrique est fournie à l'installation 2 par un réseau de distribution 3. Le réseau de distribution 3 comprend trois phases 4 et un neutre 5. Le compteur 1 est un compteur triphasé.

Le compteur 1 comprend, pour chaque phase 4, une borne de phase amont P reliée à ladite phase 4 et une borne de phase aval P' reliée à l'installation 2. Le compteur 1 comporte de plus une borne de neutre amont N et une borne de neutre aval N'.

Ici, par « amont », on entend du côté du réseau de distribution 3, et par « aval », on entend du côté de l'installation 2.

Le compteur 1 comporte de plus, pour chaque phase 4, un conducteur de phase 6 connecté à la phase 4 du réseau de distribution 3 via la borne de phase amont P, et reliant entre elles la borne de phase amont P et la borne de phase aval P'.

Le compteur 1 comporte aussi un conducteur de neutre 7 connecté au neutre 5 du réseau de distribution 3 via la borne de neutre amont N, et reliant entre elles la borne de neutre amont N et la borne de neutre aval N'.

Le compteur 1 comporte ici, pour chaque phase 4, un organe de coupure 8 comprenant un interrupteur monté sur le conducteur de phase associé. Les organes de coupure 8 sont notamment utilisés pour couper ou rétablir à distance l'alimentation de l'installation 2 en cas, par exemple, de résiliation de l'abonnement ou de non-respect du contrat d'abonnement.

Le compteur 1 comprend de plus des composants métrologiques.

Ces composants métrologiques comprennent des capteurs de tension (non représentés).

Les composants métrologiques comprennent aussi, pour chaque phase 4, un dispositif de mesure de courant 10 qui est monté en amont de l'organe de coupure 8 sur le conducteur de phase 6. Le dispositif de mesure de courant 10 permet de mesurer le courant I circulant sur ladite phase 4 et sur ledit conducteur de phase 6, qui est fourni à l'installation 2 par le réseau de distribution 3.

Le compteur 1 comporte de plus une unité de traitement 12 (électronique et logicielle). L'unité de traitement 12 comprend au moins un composant de traitement 13, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Specific Integrated Circuit*). L'unité de traitement 12 comprend aussi une ou des mémoires 14, reliées à ou intégrées dans le composant de traitement 13. Au moins l'une de ces mémoires 14 forme un support d'enregistrement lisible par ordinateur, sur lequel est enregistré au moins un programme d'ordinateur comprenant des instructions qui conduisent l'unité de traitement 12 à exécuter les étapes du procédé de mesure de courant qui sera décrit plus bas.

Ici, l'unité de traitement 12 comprend un microcontrôleur « métrologie » 13a qui appartient aux composants métrologiques et qui, notamment, acquiert les mesures réalisées par les capteurs du compteur 1 et réalise certains traitements sur lesdites mesures, et un microcontrôleur « application » 13b qui, notamment, pilote les organes de coupure 8.

On s'intéresse maintenant plus précisément aux dispositifs de mesure de courant 10.

Chaque dispositif de mesure de courant 10 comprend un transformateur de mesure de courant 20.

Les transformateurs de mesure de courant 20 sont reliés à des composants de mesure (non représentés), qui transforment en tensions de mesure les courants circulant dans les secondaires des transformateurs. Les tensions de mesure sont numérisées par un ou des convertisseurs analogiques numériques (non représentés), possiblement intégrés dans le microcontrôleur métrologie 13a, puis traitées par le microcontrôleur métrologie 13a.

Chaque dispositif de mesure de courant 10 comprend de plus un barreau principal 21 et un dispositif de barreau secondaire 22, qui sont électriquement conducteurs.

Ici, par « barreau », on entend une pièce rigide, et par « dispositif de barreau », on entend un ensemble d'au moins une pièce rigide.

Le barreau principal 21 et le dispositif de barreau secondaire 22 sont par exemple fabriqués en cuivre.

Le barreau principal 21 comprend ici une portion (ou la totalité) du conducteur de phase 6.

Le dispositif de barreau secondaire 22 comprend une première extrémité 23 et une deuxième extrémité 24 fixées au barreau principal 21, de sorte que le courant principal I se divise en un premier courant I1 circulant dans le barreau principal 21 entre la première extrémité 23 et la deuxième extrémité 24 du dispositif de barreau secondaire 22, et un deuxième courant I2 circulant dans le dispositif de barreau secondaire 22.

Le transformateur de courant 20 comprend un noyau magnétique 25 au travers duquel s'étend le dispositif de barreau secondaire 22, le transformateur de mesure de courant 20 permettant ainsi de mesurer le deuxième courant I2.

Le microcontrôleur métrologie 13a acquiert les mesures du deuxième courant I2, et produit des mesures du courant principal I à partir desdites mesures.

Le dispositif de mesure de courant 10 permet donc de diviser le courant de sorte que le deuxième courant I2, effectivement mesuré, est nettement inférieur au courant principal I. Ceci permet de réduire de manière très importante la taille et la masse du transformateur de courant 10 utilisé. On facilite ainsi l'intégration des transformateurs 20 dans le compteur 1. Le volume disponible à l'intérieur du compteur 1 est plus important, ce qui permet de positionner les transformateurs 20 à distance des parois internes du boîtier du compteur 1 et donc de rendre plus difficiles les fraudes magnétiques. De plus, les petits transformateurs génèrent un déphasage plus faible entre le courant secondaire et le courant primaire. Par conséquent, la mesure est plus précise et la correction en phase plus simple à réaliser.

On fournit un exemple d'un mode de réalisation pour illustrer l'invention.

Dans cet exemple, le courant principal I est égal à 200A. On se place à la température de 20°C.

La longueur de la portion du barreau principal 21, entre la première extrémité 23 et la deuxième extrémité 24 du dispositif de barreau secondaire 22, est égale à 20mm. Le barreau principal 21 a une épaisseur de 1,8mm pour une largeur de 25mm, ce qui donne une section selon un plan perpendiculaire à sa longueur qui est égale à 45mm². L'impédance de la portion du barreau principal 21 qui s'étend entre la première extrémité 23 et la deuxième extrémité 24, est de 7,7µΩ.

La longueur du dispositif de barreau secondaire 22 est égale à 50mm. Le dispositif de barreau secondaire 22 a une épaisseur de 0,7mm pour une largeur moyenne de 5mm, ce qui donne une section selon un plan perpendiculaire à sa longueur qui est égale à 3,5mm². L'impédance du dispositif de barreau secondaire 22 est égale à 246,3µΩ.

Le premier courant I1 circulant dans le barreau principal 21 entre la première extrémité 23 et la deuxième extrémité 24 du dispositif de barreau secondaire 22 est égal à 194A. Le deuxième courant I2 circulant dans le dispositif de barreau secondaire 22 est égal à 6A.

Le transformateur de courant 20 mesure donc un courant de 6A et non de 200A, ce qui permet de réduire ses dimensions de manière très importante.

Le ratio entre le courant détourné et le courant total consommé est proportionnel au ratio des impédances entre le barreau secondaire et le barreau principal. Ce ratio est constant quelle que soit la température, car les deux barreaux sont fabriqués en un même matériau, ici en cuivre.

On note que les incertitudes qui pourraient subsister après l'assemblage, telles que la longueur du dispositif de barreau secondaire 22 et la distance entre les deux points d'assemblage sur le barreau principal 21, peuvent être compensées par une calibration. Cette calibration est réalisée en usine.

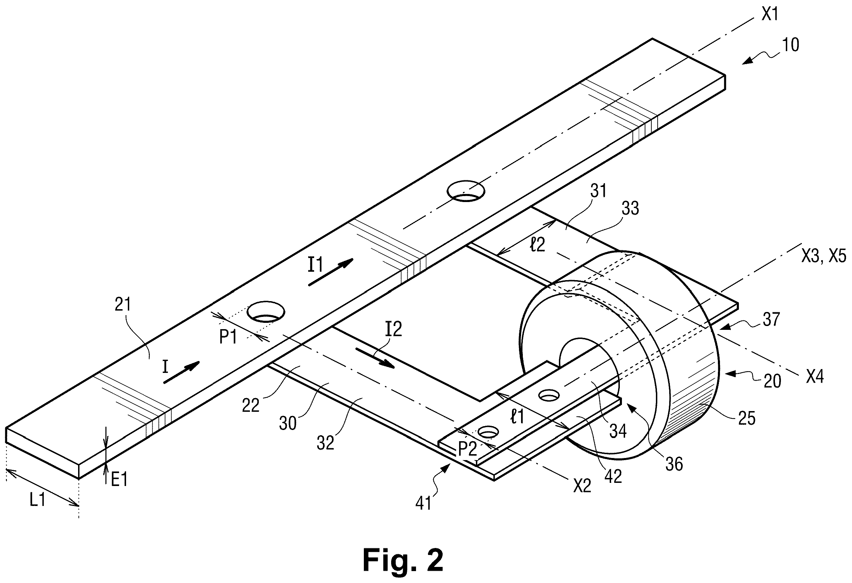

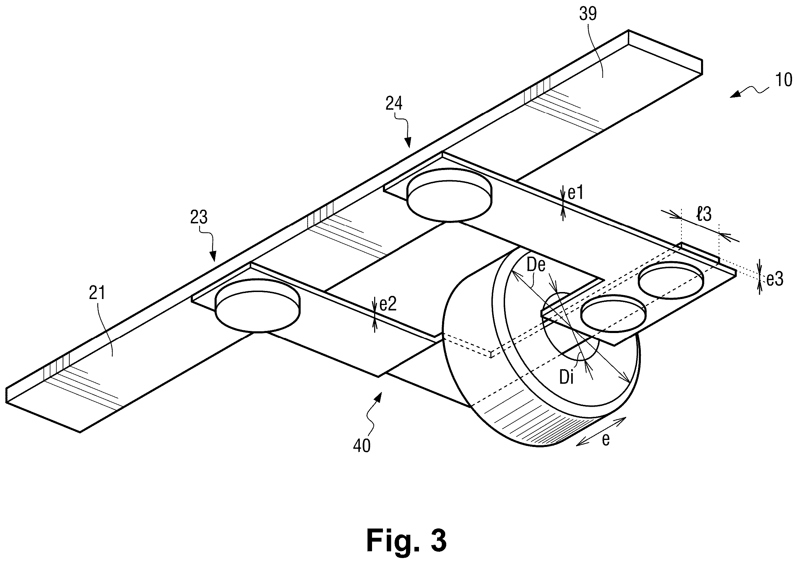

On décrit maintenant un mode de réalisation plus précis du dispositif de mesure de courant 10, en référence aux figures 2 et 3.

Le barreau principal 21 a ici la forme d'une plaque dont la longueur s'étend selon un premier axe X1.

Le dispositif de barreau secondaire 22 comprend ici deux pièces fixées l'une à l'autre : une première pièce 30 et une deuxième pièce 31. Ces deux pièces définissent un premier bras 32, un deuxième bras 33 et un troisième bras 34. Le premier bras 32 est la première pièce 30. Le deuxième bras 33 et le troisième bras 34 appartiennent à la deuxième pièce 31.

Le premier bras 32 a la forme d'un « L » comprenant une première branche qui s'étend selon un deuxième axe X2 perpendiculaire au premier axe X1, et une deuxième branche qui s'étend vers l'intérieur du dispositif de barreau secondaire 22 selon un troisième axe X3 perpendiculaire au deuxième axe X2.

La deuxième pièce 31 a la forme d'un « L » comprenant une première branche qui s'étend selon un quatrième axe X4 perpendiculaire au premier axe X1 (il s'agit du deuxième bras 33), et une deuxième branche qui s'étend vers l'intérieur du dispositif de barreau secondaire 22 selon un cinquième axe X5 perpendiculaire au quatrième axe X4 (il s'agit du troisième bras 34).

La première extrémité du premier bras 32 est la première extrémité 23 du dispositif de barreau secondaire 22. La première extrémité du deuxième bras 33 est la deuxième extrémité 24 du dispositif de barreau secondaire 22. Le troisième bras 34 est positionné entre la deuxième extrémité du premier bras 32 et la deuxième extrémité du deuxième bras 33.

Le noyau 25 du transformateur de courant 20 est monté sur le troisième bras 34. Plus précisément, le troisième bras 34 s'étend au travers du noyau 25 du transformateur de courant 20. Le diamètre interne Di du noyau 25 est très légèrement supérieur à la largeur l3 du troisième bras 34 (typiquement de 1mm).

Le dispositif de barreau secondaire 22 comporte une première butée axiale 36 et une deuxième butée axiale 37 entre lesquelles est positionné le transformateur de courant 20 et qui définissent une position axiale du transformateur de courant 20 (selon le cinquième axe X5).

La largeur l3 du troisième bras 34 est inférieure à la largeur l1 du premier bras 32 et à la largeur l2 du deuxième bras 33. La largeur l3 du troisième bras 34 est ainsi adaptée au faible diamètre interne Di du noyau 25 du transformateur de courant 20.

Cette différence de largeur a aussi pour conséquence que l'interface entre le troisième bras 34 et le premier bras 32 forme un premier épaulement constituant la première butée axiale 36, et l'interface entre le troisième bras 34 et le deuxième bras 33 forme un deuxième épaulement constituant la deuxième butée axiale 37. Le transformateur de courant 20 est donc positionné et maintenu en position entre le premier épaulement et le deuxième épaulement.

L'épaisseur e du noyau 25 est égale (ou très légèrement inférieure) à la distance entre le premier épaulement et le deuxième épaulement.

Le premier bras 32 et le deuxième bras 33 s'étendent tous deux depuis une même face 39 du barreau principal 21. La face 39 est en l'occurrence la face inférieure du barreau principal 21. Comme on l'a vu, le troisième bras 34 s'étend dans le prolongement du deuxième bras 33. Le deuxième bras 33 est plié selon une pliure 40 perpendiculaire à l'axe X4, de sorte que le troisième bras 34 est décalé en hauteur par rapport au premier bras 32 pour permettre de positionner l'extrémité libre 41 du troisième bras 34 sur une face 42 du premier bras 32 (ici la face supérieure). La configuration mécanique et géométrique du dispositif de barreau secondaire 22 pourrait être différente et on pourrait alternativement prévoir :
- que le premier bras 32 et le deuxième bras 33 sont fixés à la face supérieure et non à la face inférieure du barreau principal 21, et/ou
- que le troisième bras 34 est positionné sur la face inférieure du premier bras 32 ; dans ce cas, le deuxième bras 33 est plié vers le bas ;
- que le dispositif de barreau secondaire 22 comprend un nombre de bras ou de pièces différent, ou bien a une forme différente ;
- etc.

On s'intéresse maintenant à la fixation des différentes pièces du dispositif de mesure de courant 10.

Comme on l'a vu, le transformateur de courant 20 est monté sur le troisième bras 34 et maintenu en position entre la première butée axiale 36 et la deuxième butée axiale 37.

La première extrémité 23 et la deuxième extrémité 24 du dispositif de barreau secondaire 22 sont fixées au barreau principal 21 par clinchage.

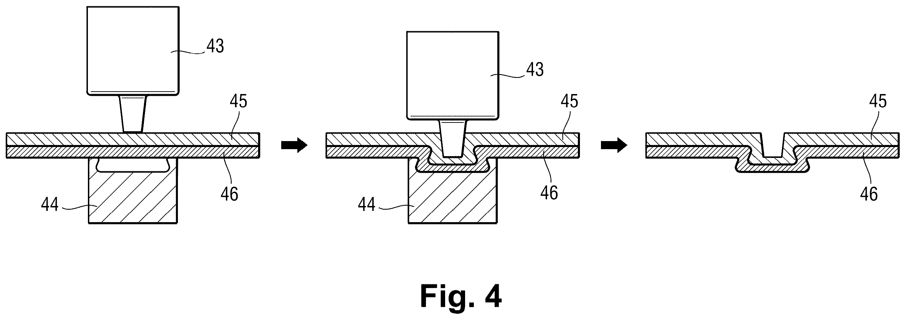

En référence à la figure 4, le clinchage nécessite l'utilisation d'un poinçon 43 et d'une matrice 44. Le clinchage permet de fixer deux tôles 45, 46 l'une à l'autre par emboutissage. Pendant le processus de clinchage, les tôles subissent une déformation plastique. Le poinçon 43 est déplacé avec la force nécessaire en fonction de l'épaisseur et de la résistance des matériaux à assembler, tandis que la matrice 44 reste fixe.

L'avantage du clinchage est qu'il est possible de mixer les épaisseurs des deux éléments à assembler. Aucun prétraitement de surface n'est nécessaire préalablement à l'opération. Aucun apport de chaleur n'est nécessaire. Ce procédé présente l'avantage de ne pas détériorer l'état de surface des métaux. Les revêtements de surface, tels qu'un étamage sur le cuivre ou un traitement contre la corrosion, sont déformés sans être détériorés. Leurs caractéristiques, telles que leur conductivité, ne sont donc pas dégradées.

Le clinchage ne nécessite pas de soudure, ce qui est avantageux car les soudures peuvent fissurer lorsqu'elles sont soumises à des variations de température élevées qu'elles peuvent rencontrer dans certains pays froids ou au cours de tests en phase de qualification.

L'épaisseur relativement importante du barreau principal 21 requiert un poinçon 43 d'un certain diamètre pour fixer la première extrémité 23 et la deuxième extrémité 24 du dispositif de barreau secondaire 22 au barreau principal 21, et donc cette épaisseur nécessite que la largeur l1 du premier bras 32 et la largeur l2 du deuxième bras 33 du dispositif de barreau secondaire 22 soient relativement importantes.

Par contre, comme l'épaisseur du dispositif de barreau secondaire 22 est moins importante, le diamètre du poinçon 43 utilisé pour assembler le dispositif de barreau secondaire 22 peut être réduit. Il est donc possible de réduire nettement la largeur l3 du troisième bras 34 pour qu'elle corresponde au diamètre interne Di réduit du noyau 25 du transformateur de courant 20.

Dans le mode de réalisation des figures 2 et 3, le barreau principal 21 a une largeur L1 de 10mm et une épaisseur E1 de 1,8mm. Le premier bras 32 et le deuxième bras 33 ont chacun une largeur l1, l2 de 10mm et une épaisseur e1, e2 de 0,7mm. Le troisième bras 34 a une largeur l3 de 5mm et une épaisseur e3 de 0,7mm. Le diamètre externe De du noyau 25 du transformateur de courant 20 est égal à 20mm. Le diamètre interne Di du noyau 25 est égal à 6mm. L'épaisseur e du noyau 25 est égale à 10mm.

Le diamètre P1 du poinçon 43 utilisé pour fixer le dispositif de barreau secondaire 22 au barreau principal 21 est ici égal à 4mm.

Le diamètre P2 du poinçon 43 utilisé pour fixer la deuxième pièce 31 à la première pièce 30 du dispositif de barreau secondaire 22, et donc le troisième bras 34 au premier bras 31, est ici égal à 2,5mm.

Bien entendu, l'invention n'est pas limitée au mode de réalisation décrit mais englobe toute variante entrant dans le champ de l'invention.

Le dispositif de barreau secondaire pourrait être fixé au barreau principal de manière différente. La première extrémité et la deuxième extrémité du dispositif de barreau secondaire pourraient par exemple être fixées au barreau principal par rivetage à chaud ou à froid, ou par soudure électrique par point.

Le compteur électrique peut être un compteur monophasé ou polyphasé comprenant un nombre de phases différent de trois.

Le dispositif de courant peut être intégré dans un équipement électrique autre qu'un compteur électrique, et par exemple dans un disjoncteur.

## Revendications

1. Dispositif de mesure de courant (10), agencé pour mesurer un courant principal (I) circulant dans le dispositif de mesure de courant, et comprenant :
- un barreau principal (21) ;
- un dispositif de barreau secondaire (22) comprenant une première extrémité (23) et une deuxième extrémité (24) fixées au barreau principal, de sorte que le courant principal se divise en un premier courant (I1) circulant dans le barreau principal entre la première extrémité et la deuxième extrémité du dispositif de barreau secondaire, et un deuxième courant (I2) circulant dans le dispositif de barreau secondaire ;
- un transformateur de courant (20), comprenant un noyau magnétique (25) au travers duquel s'étend le dispositif de barreau secondaire (22), le transformateur de courant permettant ainsi de mesurer le deuxième courant qui est représentatif du courant principal,
le dispositif de barreau secondaire (22) comportant une première butée axiale (36) et une deuxième butée axiale (37) entre lesquelles est positionné le transformateur de courant (20) et qui définissent une position axiale du transformateur de courant (20).

2. Dispositif de mesure de courant selon la revendication 1, dans lequel la première extrémité (23) et la deuxième extrémité (24) du dispositif de barreau secondaire (22) sont fixées au barreau principal (21) par clinchage.

3. Dispositif de mesure de courant selon la revendication 1, dans lequel la première extrémité (23) et la deuxième extrémité (24) du dispositif de barreau secondaire (22) sont fixées au barreau principal (21) par rivetage à chaud ou à froid, ou par soudure électrique par point.

4. Dispositif de mesure de courant selon l'une des revendications précédentes, dans lequel le dispositif de barreau secondaire (22) comprend un premier bras (32) dont une première extrémité est la première extrémité (23) du dispositif de barreau secondaire, un deuxième bras (33) dont une première extrémité est la deuxième extrémité (24) du dispositif de barreau secondaire, et un troisième bras (34) positionné entre une deuxième extrémité du premier bras et une deuxième extrémité du deuxième bras, le troisième bras s'étendant au travers du noyau magnétique (25) du transformateur de courant (20).

5. Dispositif de mesure de courant selon la revendication 4, dans lequel une largeur (l3) du troisième bras (34) est inférieure à une largeur (l1) du premier bras (32) et à une largeur (l2) du deuxième bras (33), de sorte que l'interface entre le troisième bras et le premier bras forme un premier épaulement constituant la première butée axiale (36) et l'interface entre le troisième bras et le deuxième bras forme un deuxième épaulement constituant la deuxième butée axiale (37).

6. Dispositif de mesure de courant selon l'une des revendications 4 ou 5, dans lequel le premier bras (32) et le deuxième bras (33) s'étendent tous deux depuis une même face (39) du barreau principal (21), dans lequel le troisième bras (34) s'étend dans le prolongement deuxième bras (33), et dans lequel le deuxième bras est plié de sorte que le troisième bras (34) est décalé en hauteur par rapport au premier bras pour permettre de positionner une extrémité libre (41) du troisième bras sur une face (42) du premier bras (32).

7. Equipement électrique (1) comprenant au moins un dispositif de mesure de courant (10) selon l'une des revendications précédentes.

8. Equipement électrique (1) selon la revendication 7, l'équipement électrique étant un compteur électrique.
